(19)

**Europäisches Patentamt**
**European Patent Office**
**Office européen des brevets**

(11) **EP 4 253 593 A1**

(12) **EUROPEAN PATENT APPLICATION**

(43) Date of publication:
**04.10.2023 Bulletin 2023/40**

(21) Application number: **23164842.9**

(22) Date of filing: **28.03.2023**

(51) International Patent Classification (IPC):
**C23C 4/11** (2016.01)          **C23C 4/134** (2016.01)

(52) Cooperative Patent Classification (CPC):
**C23C 4/11; C23C 4/134**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.04.2022 US 202263326497 P**

(71) Applicant: **Raytheon Technologies Corporation Farmington, CT 06032 (US)**

(72) Inventors:
• **BURLATSKY, Sergei F.**
  **West Hartford, 06117 (US)**
• **FURRER, David U.**
  **Marlborough, 06447 (US)**

(74) Representative: **Dehns**
  **St. Bride's House**
  **10 Salisbury Square**
  **London EC4Y 8JD (GB)**

(54) **SUSPENSION PLASMA SPRAY COLUMNAR GROWTH CONTROL METHODS AND ARTICLES MANUFACTURED THEREFROM**

(57)    Disclosed herein is a suspension plasma spray process that comprises suspending metal oxide particles in a carrier fluid to produce a suspension. The suspension is ejected onto a substrate via a plasma flame. The particles are evaporated in the plasma flame to form a gaseous ceramic during their travel to the substrate. The gaseous ceramic is deposited on the substrate to form columnar grains.

EP 4 253 593 A1

**Description**

BACKGROUND

Disclosed herein is a method for controlling columnar growth using suspension plasma spray (SPS) and articles manufactured from the foregoing method. In particular, disclosed herein is a method for controlling columnar growth in a thermal barrier coating using suspension plasma spray. Disclosed herein too are articles manufactured by the foregoing method.

There is a need to produce thermal barrier coatings (TBC) coatings that are columnar in morphology to enable strain tolerance and durability. Electron beam physical vapor deposition (EBPVD) is a technique that is used to produce coatings that have a columnar morphology in which a high energy electron beam is used to heat the target material and the target material is deposited on the component substrate in the molecular form under high vacuum conditions. EBPVD is a traditional approach to produce ceramic TBC coatings that use epitaxially grown ceramic grain columns on component substrates. TBC columnar coatings produced by traditional EBPVD processes have some drawbacks - notably that they are expensive.

Traditional plasma spray processes involve a plasma heating source to melt ceramic particles present in a liquid that are then injected then into the plasma stream. The ceramic particles in their liquid form are transferred to a component substrate where they produce layers of liquid or partially liquid splats on the substrate. The splats are then solidified. As splats are continuously added to the component substrate a layered ceramic coating is produced. The layered ceramic coatings produced by these traditional plasma spray processes have some drawbacks - notably, that they do not provide for strain tolerance and lack the desired durability. It is therefore desirable to produce columnar structures for TBC coatings in a manner similar to that produced in an EBPVD method but at a much lower cost and using processes that are less complicated.

SUMMARY

In one aspect, there is provided a suspension plasma spray process comprises suspending metal oxide particles in a carrier fluid to produce a suspension; ejecting the suspension onto a substrate via plasma flame; evaporating the particles in the plasma flame to form a gaseous ceramic during their travel to the substrate; and depositing the gaseous ceramic on the substrate to form columnar grains.

Optionally, in an example of the above, an evaporation temperature of the metal oxide particles is proportional to particle size.

Optionally, in an example of any of the above, vapor pressure of the evaporated metal oxide particles is proportional to a temperature of the plasma flame.

Optionally, in an example of any of the above, the columnar grains are produced by epitaxial growth.

Optionally, in an example of any of the above, a travel distance of the metal oxide particles in the plasma flame is greater than an evaporation distance; where evaporation distance is an average distance from a plasma orifice to a point that the metal oxide particle evaporates in the plasma flame.

Optionally, in an example of any of the above, a particle evaporation time in the plasma flame is defined by Equation (1):

$$t_{ev} = \frac{a_0 \rho_{ox} 2RT_{ox}}{M_{ox} P_{ox}(T_{ox}) V_{T,ox}}$$

(1),

where $t_{ev}$ is particle evaporation time, $a_0$ is initial oxide particle size that decreases with evaporation, $\rho_{ox}$ is the density of the metal oxide particles, $T_{ox}$ is the melting temperature of the metal oxide particles, $M_{ox}$ is the metal oxide molecular weight, $P_{ox}$ is metal oxide saturated vapor pressure and $P_{ox}(T_{ox})$ is equilibrium pressure of oxide vapor at oxide particle temperature T and $V_{T,ox}$ is thermal velocity of the metal oxide molecules at a given temperature, and R is the universal gas constant.

Optionally, in an example of any of the above, a metal oxide particle temperature in the plasma flame is calculated from an energy balance given by Equation (2):

$$\frac{3}{2} R(T_{gas} - T_{ox}) \frac{P_{gas} V_{T\,gas}}{RT_{gas}} = \Delta H_{ev} \frac{P_{ox}(T_{ox}) V_{T,ox}}{RT_{ox}}$$

(2),

where $V_{T ox}$ is thermal velocity of the metal oxide molecules at temperature T, $T_{ox}$ is the temperature of the metal oxide particle, $T_{gas}$ is the "environmental' temperature in the chamber, $P_{gas}$ is the pressure in the chamber; $\Delta H_{ev}$ is the heat of evaporation of the particles, $P_{ox}$ is metal oxide saturated vapor pressure and $P_{ox}(T_{ox})$ is equilibrium pressure of oxide vapor at oxide particle temperature T and $V_{T, ox}$ is thermal velocity of the metal oxide molecules at a given temperature, and R is the universal gas constant.

Optionally, in an example of any of the above, a metal oxide particle evaporation rate is governed by particle temperature.

Optionally, in an example of any of the above, a metal oxide particle evaporation time is proportional to metal oxide particle size for a given plasma temperature.

Optionally, in an example of any of the above, the metal oxide particle evaporation distance is proportional to metal oxide particle size.

Optionally, in an example of any of the above, a metal oxide particle evaporation distance is inversely proportional to plasma temperature for a given particle size.

Optionally, in an example of any of the above, the metal oxide particle evaporation distance is proportional to a gas flow rate for a given particle size and plasma temperature.

Optionally, in an example of any of the above, the metal oxide particle evaporation time is proportional to a gas flow rate.

Optionally, in an example of any of the above, the suspension comprises a carrier fluid; where the carrier fluid is water or an alcohol.

Optionally, in an example of any of the above, the carrier fluid is used in an amount of 20 to 95 weight percent, based on the total weight of the suspension.

Optionally, in an example of any of the above, the metal oxide particle comprises a 7YSZ ceramic.

Optionally, in an example of any of the above, the metal oxide particle comprises a silicate, a zirconia, a titania, an alumina, a zirconate, a titanate, an aluminate, a stannate, a niobate, a tantalate, a tungstate or a rare earth oxide.

Optionally, in an example of any of the above, the metal oxide particle has an average particle size of 50 nanometers to 10 micrometers.

BRIEF DESCRIPTION OF THE DRAWINGS

The following descriptions should not be considered limiting in any way. With reference to the accompanying drawings, like elements are numbered alike:

FIG. 1 depicts the relationship between evaporation time and particle size at different plasma temperatures;

FIG. 2A is a graph that details the oxide particle pressure and its dependence on plasma temperature respectively;

FIG. 2B is a graph that details the oxide vapor pressure and its dependence on plasma temperature respectively;

FIG. 3A is a graph that details particle size with plasma temperature as a function of evaporation time;

FIG. 3B is a graph that details particle size with plasma temperature as a function of evaporation temperature;

FIG. 3C is a graph that details particle size with plasma temperature as a function of evaporation time; and

FIG. 3D is a graph that details particle size with plasma temperature as a function of evaporation temperature.

DETAILED DESCRIPTION

A detailed description of one or more embodiments of the disclosed apparatus and method are presented herein by way of exemplification and not limitation with reference to the Figures.

Disclosed herein is a method of using suspension plasma spray to produce consistent thermal barrier coatings (TBC) that have a columnar morphology that enables strain tolerance and durability during high temperature operations. The method comprises dispersing a ceramic feedstock in a liquid suspension before injecting the ceramic feedstock into the plasma jet. The plasma jet directs the ceramic material toward a substrate to form the columnar morphology. The plasma jet converts the ceramic particles of the feedstock into a vapor phase that comes in contact with the surface of the substrate where the vapor condenses to form the thermal barrier coating. The ceramic material that is injected into the plasma is heated to a gaseous form. It is to be noted that in this process the original solid ceramic particles that were injected into the plasma do not simply melt and do not splat upon the substrate. Splatting of metal particles on the substrate is obviated (because of the conversion to vapor) by the methodology used in this disclosure.

The resultant thermal barrier coating is more effective from an operational strain perspective and enables lower cost processing with economics that approach that of thermal spray processing while producing a columnar morphology that is typically produced by electron beam plasma vapor deposition. In other words, the SPS process can be used to produce columnar structures but at a lower cost compared with other spray processes such as EBPVD.

Columnar grain structures are advantageous for coatings in that these structures improve coating life through a reduction or even elimination of thermal stress. Columnar grain structures allow for separation of individual columnar grains during heating, abrasion and/or shear processes. The substrate upon which these columnar grain structures are disposed generally comprise metals that expand an appreciable amount when compared with that of the ceramic TBC coating. As the metallic substrate expands, the columnar TBC will remain attached at the surface of the substrate, but the individual columns will separate from each other at high temperature and will come back together at lower temperatures, thus minimizing damage to the TBC coating.

In other words, the coating formed on the substrate has vertical gaps or cracks that enable the coating to better handle strain in a plane parallel to the coating surface (or in a plane parallel to the surface of the substrate). In an embodiment, the vertical gaps or cracks are substantially perpendicular to the surface of the substrate upon which the coating is disposed. In an embodiment, at least a portion of the gaps or cracks are perpendicular to a free surface of the coating (the free surface being the surface that contacts the atmosphere) or to the surface of the substrate.

The ability of the TBC coating to expand and contract with temperature variations minimizes damage to the TBC coating, increasing the operating life cycle of the part in addition to reducing maintenance costs.

In an embodiment, the process parameters affect certain factors of the coating, such as the size and distribution of residual stresses, macro and microcracks, factors which have an important influence on the performance and eventual failure of the coating. The spray parameters are in turn dependent upon material characteristics and process characteristics such as, for example, particle size, particle separation in suspension, particle injection rate, plasma temperature, controls for axillary heating, length of plasma plume, distance from plasma torch and part surface, gas flow rate, electrical field strength, substrate surface temperature, substrate surface roughness and chemistry, amongst other parameters. Since there are such a large number of parameters that determine the quality of the columnar structures produced by SPS, it is desirable to develop a predictive model that facilitates control of the columnar structures which in turn determines the quality of the TBC coating.

More specifically it is desirable to predict deposition structure from critical processing parameters such as textured epitaxial grown columns, equiaxed epitaxial grown columns, layers, controlled mixtures of morphologies, and the like. The predictive model may include predictions of melting of particles, a prediction of the vaporization of particles, a prediction of residence time in plasma and a prediction of deposition rates of the ceramic during the SPS process.

Materials used in the SPS process include but are not limited to ceramics for thermal or environmental barrier coatings, such as a family of 7YSZ-type ceramics (e.g., $ZrO_2$ containing 7wt% $Y_2O_3$), and abradable seals, such as alumina and the like. These are described below.

Prior to detailing the predictive model, the materials used in the SPS process will be described. The suspension comprises a carrier liquid with fine solid particles (e.g., the particles of the TBC material that eventually form the coating upon being disposed on a desired substrate). The carrier liquid is preferably one that can either suspend the particles permanently or at least for short period of time during the spray process. The carrier liquid provides the mass to transfer the solid particles into the plasma plume. The carrier liquid evaporates and/or combusts and the solid particles evaporate upon contacting (and exposure to a specific residence time in) the plasma flame converting the fine solid particles in gaseous form which comes in contact with the substrate and forms the columnar coating.

Surfactants and dispersants that do not disrupt the structure or performance of the columnar coating may optionally be used to suspend smaller particles (e.g., nanoparticles) in the liquid if desired. Waxes and polymers (that are soluble in the liquid) may also optionally be added to the liquid to serve as sacrificial pore formers in the coating if desired.

The liquid used for the suspension may include polar solvents, non-polar solvents, or combinations thereof. The polar solvents may be aprotic solvent, protic solvents, or combinations thereof. Liquid aprotic polar solvents may include water, propylene carbonate, ethylene carbonate, butyrolactone, acetonitrile, benzonitrile, nitromethane, nitrobenzene, sulfolane, dimethylformamide, N- methylpyrrolidone, or the like, or a combination thereof. Polar protic solvents may include alcohols (e.g., methanol, ethanol, butanol, isopropanol, and the like), acetonitrile, nitromethane, or the like, or a combination thereof. Non-polar solvents such a benzene, toluene, methylene chloride, carbon tetrachloride, hexane, diethyl ether, tetrahydrofuran, or the like, or a combination thereof. Ionic liquids including imidazolium salts, may also be used as the carrier liquid if desired.

A preferred solvent for use in the suspension is water or an alcohol. A preferred alcohol is ethanol. The solvent may be used in amounts of 20 to 95, preferably 25 to 90, and more preferably 35 to 80 weight percent (wt%) based on the total weight of the suspension.

The particles used in the suspension for coating substrates are typically the same chemistry as those used in tribological coatings, environmental barrier coatings or thermal barrier coatings in gas turbine engines that are subject to elevated operating temperatures. In an embodiment, the particles used in the suspension include metal oxides including perovskites, zirconate or hafnate base ceramic compounds, zirconate or hafnate based ceramic compounds that have a cubic or tetragonal or tetragonal prime crystal structure, yttria stabilized zirconia (YSZ), cubic zirconia based ceramics such as, for example, gadolinia zirconia. Zr-Ta-Y ternary systems of the cubic, fluorite or orthorhombic crystal structure, or having a combination of the foregoing crystal structures may also be used. Details of some of these particles are provided below.

General examples of metal oxides that may be used as particulates in the suspension comprise silicates, zirconia, titania, alumina, zirconates, titanates, aluminates, stannates, niobates, tantalates, tungstates, and rare earth oxides. The aforementioned metal oxides may be used either singly or in alloys with other metals or metals oxides. In a preferred embodiment, alumina may be used singly while the other metal oxides are used in alloy form. Metal oxide modified 7YSZ-type ceramics may also be used. The aforementioned metal oxides may be used to modify the 7YSZ-type ceramic.

As noted above, alumina and silicate based materials can also be used as particles in the suspension. The silicates may be based on the mono- and di-silicate systems, for example with ytterbia or yttria as the anion (e.g., YbSiOs, $Yb_2Si_2O_7$, $Y_2SiO_5$, $Y_2Si_2O_7$, or a combination thereof). Other materials such as Halfnon ($HfSiO_4$) may also be used. The alumina base material comprises mullite ($Al_6SiO_{13}$).

Perovskite materials may also be used and have the general structural formula $ABO_3$, where A is Mg, Ca, Sr, Ba, or a combination thereof and B is Al, Mn, Si, Ti, Zr, Co, Ni, Sn, or a combination thereof. Rare earth perovskites may also be used as particulates in the suspension. An example of a rare earth perovskite $La(1-x)AxCr(1-y)ByO_3$ where A is Mg, Ca, Sr, Ba, or a combination thereof and B is Al, Mn, Si, Ti, Zr, Co, Ni, Sn, or a combination thereof, with x = 0 to 1, preferably 0.05 to 0.8, and more preferably 0.1 to 0.5 and y = 0 to 1, preferably 0.05 to 0.8, and more preferably 0.1 to 0.5. Examples of perovskites include $CaTiO_3$, $MgTiO_3$, $CaSiO_3$, $CaSnO_3$, $CaZrO_3$, $MgZrO_3$, $BaZrO_3$, $SrZrO_3$, $BaSnO_3$, $CaSnO_3$, $MgSnO_3$, $SrTiO_3$, or the like, or a combination thereof.

Partially or fully stabilized zirconia or hafnia may also be used as particles in the suspension. The stabilized zirconia may include yttria-, calcia-, magnesia-, ceria-, scandia, lanthanide series elements, hafnia- or alumina-stabilized zirconia or combinations thereof. Fully stabilized zirconia including 20YSZ (yttria-stabilized zirconia containing 20 wt% yttria) and $Gd_2Zr_2O_7$ may be used as particles in the suspension. Other stabilized zirconias such as, for example, FSZ (Fully Stabilized Zirconia), CSZ (Cubic Stabilized Zirconia), 8YSZ (having 8 mole percent $Y_2O_3$ Fully Stabilized $ZrO_2$) and 8YDZ (having 8 to 9 mole percent $Y_2O_3$-doped $ZrO_2$), 7YSZ, or combinations thereof, may be used as particles in the suspension. Yttria stabilized zirconia comprising 4 to 9 mole percent of the yttria are preferred, with those having 7 to 9 mole percent more preferred, based on the total number of moles of the yttria stabilized zirconia.

Process Parameters

Particle Size

In an embodiment, the ceramic feedstock in particulate form is dispersed in a liquid suspension before being injected into a plasma jet that directs the feedstock vapors in gaseous form onto a substrate. The particles are of a size that can be vaporized in the plasma during their travel to the substrate. By suspending the ceramic feedstock in powder form in a fluid, normal feeding problems are circumvented, allowing the deposition of finer microstructures through the use of finer powders.

In an embodiment, the maximum particle size of the powder is selected such that the particles vaporize in the plasma jet prior to impacting the substrate. Since particle evaporation time is proportional to particle size, the particle size determines the resident time in the plasma, which in turn determines the size (length) of the plasma jet. As noted above, it is desirable for the powder to be a metal oxide powder, where the metal oxide vapor pressure is proportional to the metal oxide vapor pressure.

In an embodiment, the maximum particle sizes (of the ceramic feedstock) are of a size to enable heating to a temperature where the ceramic vaporizes. As a part of the developed technology an analytical model has been developed to determine the specific maximum powder size that is allowed in the controlled process to fully vaporize the ceramic powder feedstock. The maximum powder size is related to the temperature of the plasma, and the residence time of the powder in the plasma and associated parameters.

Particle evaporation time can be estimated as

$$t_{ev} = \frac{a_0 \rho_{ox} 2RT_{ox}}{M_{ox} P_{ox}(T_{ox}) V_{T,ox}} \qquad (1),$$

where $t_{ev}$ is particle evaporation time, $a_0$ is initial oxide particle size that decreases with evaporation, $\rho_{ox}$ is the density of the metal oxide particles, $T_{ox}$ is the melting temperature of the metal oxide particles, $M_{ox}$ is the metal oxide molecular weight, $P_{ox}$ is metal oxide saturated vapor pressure and $P_{ox}(T_{ox})$ - is equilibrium pressure of oxide vapor at oxide particle temperature T and $V_{T,ox}$ is thermal velocity of the metal oxide molecules at a given temperature, and R is the universal gas constant.

The metal oxide particle temperature may be determined by Equation (2) and may be calculated by using an energy balance:

$$(2),$$

where $V_{Tox}$ is thermal velocity of the metal oxide molecules at temperature T, $T_{ox}$ is the temperature of the metal oxide particle, $T_{gas}$ is the "environmental' temperature in the plasma chamber (plasma/gas temperature), $P_{gas}$ is the gas pressure in the plasma chamber; $\Delta H_{ev}$ is the heat of evaporation of the particles, and the other terms have their meanings as explained above in the Equation (1). Particles are heated by collisions with gas/ plasma and cooled by evaporation. The heat transfer through collisions is proportional to the temperature difference between the gas and particles.

In an embodiment, the particle size and plasma temperature both determine particle evaporation time in the plasma. It is desirable to choose a particle size that is proportional to the residence time of the particle in the plasma. Larger particles would therefore use a larger residence time, while smaller particles would use a smaller residence time in the plasma. In short, the residence time in the plasma would determine the time for the particle to evaporate, since it is desirable for the particle to be in vapor (gaseous) form when it contacts the substrate.

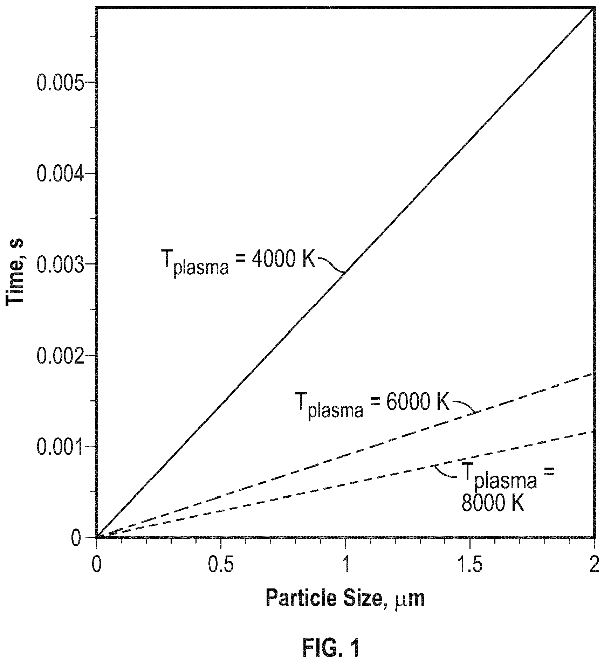

FIG. 1 depicts the relationship between evaporation time and particle size at different plasma temperatures. From the FIG. 1 it may be seen that for a given particle size, there is a shorter evaporation times at higher plasma temperature than at a lower plasma temperature. For example, a particle having an average particle size of 1 micrometer uses an evaporation time that is approximately 6 times longer at 4000 Kelvin than at a temperature of 8000 Kelvin. Thus, higher temperatures and smaller particle sizes facilitate a lower evaporation time and hence a shorter residence time in the plasma. This can facilitate efficiency of the process in addition to producing the columnar structures on the substrate.

Additionally, since it is required for the particles to be in vapor form prior to impacting the substrate, the plasma temperature which may be used to determine particle size and the characteristics of the suspension may also determine the length of the plasma plume. The interaction between the plasma temperature and particle size may be used to determine the length of the plasma plume. For a given particle size, at higher temperatures the plasma plume may be of a shorter length than at lower temperatures because at higher temperatures the particle will vaporize much faster than at lower temperatures. Higher temperatures may also enable the use of larger particles while maintaining a constant plasma plume length.

The solid particles of the ceramic feedstock prior to suspension generally have an average particle size that ranges from 50 nanometers to 10 micrometers, preferably 100 nanometers to 5 micrometers. In a preferred embodiment, based on the preferred parameters that control heating of the solid particles in suspension, it is desirable for the metal oxide particles to have an average particle size that is less than 2.5 micrometers. In an embodiment, the particles in suspension have a particle size of 50 nanometers to 2.5 micrometers, preferably 10 nanometers to 1.5 micrometers. The solid particles may be used in amounts of 5 to 70, preferably 10 to 65, and more preferably 20 to 60 volume percent, based on the total volume of the suspension. In an exemplary embodiment, the solid particles may be used in amounts of 5 to 40 volume percent, based on the total volume of the suspension. It is desirable for the suspension to not be in the form of a slurry.

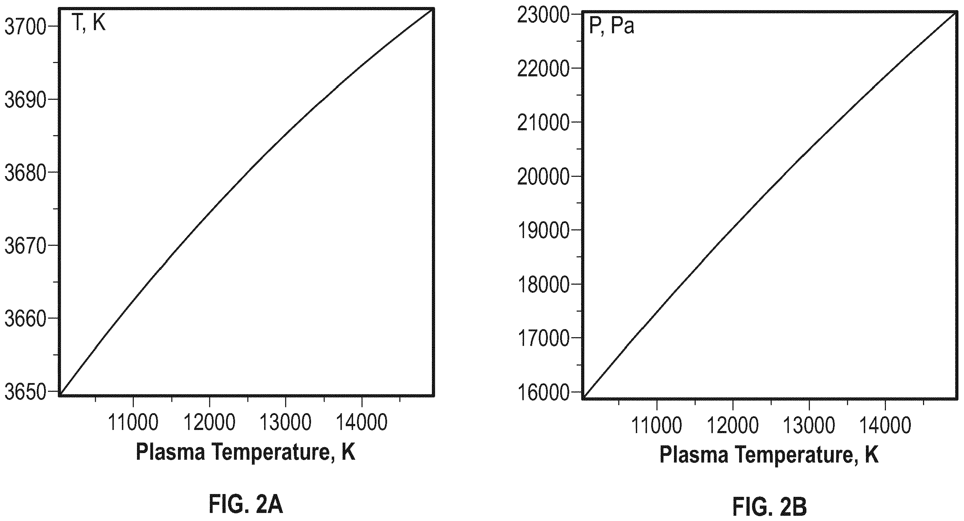

FIGS. 2A and 2B detail the oxide particle pressure and oxide vapor pressure and its dependence on plasma temperature respectively. As noted above, it is desirable for the powder that is dispersed in the suspension to be a metal oxide powder. FIG. 2A depicts oxide particle temperature increasing with the plasma temperature. FIG. 2B depicts the metal oxide vapor pressure as a function of plasma temperature. FIGS. 2A and 2B provide results of the developed analytical model for a specific example ceramic material. They convey the relationship of ceramic powder surface temperature and pressure respectively during evaporation for a given plasma temperature. The pressure is useful for the purpose of calculating evaporation rate and subsequently the time to evaporate the entire powder particle.

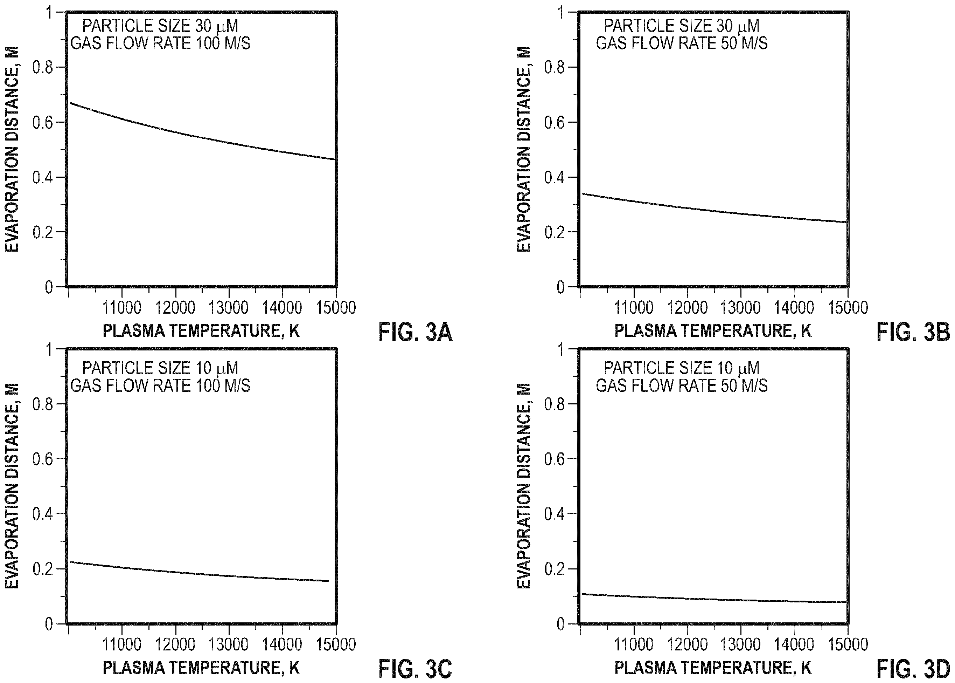

FIGS. 3A - 3D depict example model outputs that show particle evaporation distance and their relationship to particle size and particle velocity and plasma temperature. Evaporation distance is plotted as a function of plasma temperature. Evaporation distance is an average distance from a plasma orifice to a point that the metal oxide particle evaporates in the plasma. In these figures, temperature varies from 10,000 to 15,000 Kelvin. In these graphs, the particle size is selected to be 10 (FIGS. 3C and 3D) and 30 micrometers (FIGS. 3A and 3B) respectively. Gas flow rates are 50 meters per second (FIGS. 3A and 3C) and 100 meters per second (FIGS. 3B and 3D) respectively.

From these FIGS. 3A - 3D, it may be seen that smaller particle sizes require smaller evaporation distances for a given gas flow rate. In other words, evaporation distance and evaporation time in the plasma flame is proportional to particle size and inversely proportional to plasma temperature. Alternatively, a slower gas flow rate produces evaporation of the particles in a shorter distance from the plasma orifice. Evaporation distance is proportional to gas flow rate. In other words, melting of the particles in the plasma jet can be accomplished by reducing particle size, reducing the rate of gas flow in the plasma jet, increasing the length of the plasma jet to the substrate (i.e., the distance from the plasma orifice to the substrate) or increasing the temperature.

In the FIGS. 3A - 3D it is desirable to operate in the evaporation distance regime that lies above the curve in each of the graphs. In short, for a given particle size and a given gas flow rate it is desirable to have a distance between the plasma orifice to substrate that is greater than the evaporation distance. In other words, the distance travelled by the particles in their gaseous state is greater than the evaporation distance for a given plasma temperature and size.

In an embodiment from the FIGS. 2A, 2B and 3A - 3D, it may be seen that an evaporation temperature of the metal oxide particles is proportional to particle size. In another embodiment, the vapor pressure of the evaporated metal oxide particles is proportional to a temperature of the plasma flame. In yet another embodiment, a travel distance of the metal oxide particles in the plasma flame is greater than an evaporation distance; where evaporation distance is an average distance from a plasma orifice to a point that the metal oxide particle evaporates in the plasma flame.

In an embodiment, the metal oxide particle evaporation rate is governed by particle temperature. In yet another embodiment, a metal oxide particle evaporation time is proportional to metal oxide particle size for a given plasma temperature. In yet another embodiment, the metal oxide particle evaporation distance is proportional to metal oxide particle size.

In an embodiment, a metal oxide particle evaporation distance is inversely proportional to plasma temperature for a given particle size. In an embodiment, the metal oxide particle evaporation distance is proportional to a gas flow rate for a given particle size and plasma temperature. In another embodiment, a metal oxide particle evaporation time is proportional to a gas flow rate. The columnar grains are produced by epitaxial growth.

In summary, there are a number of parameters that can influence the production and transfer of vapor phase to the substrate surface such as, for example, the particle size, where depending upon plasma temperature, a smaller particle size facilitates rapid evaporation of the particles. Increasing the particle size is generally accompanied by an increase in plasma temperature or an increase in the travel distance to the substrate from the plasma orifice. Reducing travel velocity of the particles can also facilitate increased residence time and evaporation of the particles prior to deposition on the substrate.

In summary, SPS is a process where a plasma plume is used to both heat and propel ceramic material (metal oxide powder particles) toward the surface of the substrate. To develop columnar grains by epitaxial growth, the ceramic powder that is injected into the plasma is completely vaporized to produce the desired ceramic vapor that can be transported by the momentum of the plasma stream to the substrate surface. In summary, the temperature of the plasma, resident time of the powder within the plasma and the size of the powder are several of the parameters that are detailed in this disclosed and are controlled to enable the consistent columnar grains.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

**Claims**

1. A suspension plasma spray process comprising:

   suspending metal oxide particles in a carrier fluid to produce a suspension;
   ejecting the suspension onto a substrate via plasma flame;
   evaporating the particles in the plasma flame to form a gaseous ceramic during their travel to the substrate; and
   depositing the gaseous ceramic on the substrate to form columnar grains.

2. The suspension plasma spray process of claim 1, wherein an evaporation temperature of the metal oxide particles is proportional to particle size.

3. The suspension plasma spray process of claim 1 or 2, wherein vapor pressure of the evaporated metal oxide particles is proportional to a temperature of the plasma flame.

4. The suspension plasma spray process of any preceding claim, wherein the columnar grains are produced by epitaxial growth.

5. The suspension plasma spray process of any preceding claim, wherein a travel distance of the metal oxide particles in the plasma flame is greater than an evaporation distance; where evaporation distance is an average distance from a plasma orifice to a point that the metal oxide particle evaporates in the plasma flame.

6. The suspension plasma spray process of any preceding claim, wherein a particle evaporation time in the plasma flame is defined by Equation (1):

$$t_{ev} = \frac{a_0 \rho_{ox} 2RT_{ox}}{M_{ox} P_{ox}(T_{ox}) V_{T,ox}} \tag{1},$$

where $t_{ev}$ is particle evaporation time, $a_0$ is initial oxide particle size that decreases with evaporation, $\rho_{ox}$ is the density of the metal oxide particles, $T_{ox}$ is the melting temperature of the metal oxide particles, $M_{ox}$ is the metal oxide molecular weight, $P_{ox}$ is metal oxide saturated vapor pressure and $P_{ox}(T_{ox})$ is equilibrium pressure of oxide vapor at oxide particle temperature T and $V_{T,ox}$ is thermal velocity of the metal oxide molecules at a given temperature, and R is the universal gas constant.

7. The suspension plasma spray process of any preceding claim, wherein a metal oxide particle temperature in the plasma flame is calculated from an energy balance given by Equation (2):

$$\frac{3}{2} R(T_{gas} - T_{ox}) \frac{P_{gas} V_{T\,gas}}{RT_{gas}} = \Delta H_{ev} \frac{P_{ox}(T_{ox}) V_{T,ox}}{RT_{ox}} \tag{2},$$

where $V_{Tox}$ is thermal velocity of the metal oxide molecules at temperature T, $T_{ox}$ is the temperature of the metal oxide particle, $T_{gas}$ is the "environmental' temperature in the chamber, $P_{gas}$ is the pressure in the chamber; $\Delta H_{ev}$ is the heat of evaporation of the particles, $P_{ox}$ is metal oxide saturated vapor pressure and $P_{ox}(T_{ox})$ is equilibrium pressure of oxide vapor at oxide particle temperature T and $V_{T,ox}$ is thermal velocity of the metal oxide molecules at a given temperature, and R is the universal gas constant.

8. The suspension plasma spray process of any preceding claim, wherein a metal oxide particle evaporation rate is governed by particle temperature.

9. The suspension plasma spray process of any preceding claim, wherein a metal oxide particle evaporation time is proportional to metal oxide particle size for a given plasma temperature, and/or wherein the metal oxide particle evaporation distance is proportional to metal oxide particle size.

10. The suspension plasma spray process of any preceding claim, wherein a metal oxide particle evaporation distance is inversely proportional to plasma temperature for a given particle size, wherein the metal oxide particle evaporation distance is optionally proportional to a gas flow rate for a given particle size and plasma temperature.

11. The suspension plasma spray process of any preceding claim, wherein the metal oxide particle evaporation time is proportional to a gas flow rate.

12. The suspension plasma spray process of any preceding claim, wherein the carrier fluid is water or an alcohol.

13. The suspension plasma spray process of any preceding claim, wherein the carrier fluid is used in an amount of 20 to 95 weight percent, based on the total weight of the suspension.

14. The suspension plasma spray process of any preceding claim, wherein the metal oxide particle comprises a 7YSZ ceramic; and/or wherein the metal oxide particle comprises a silicate, a zirconia, a titania, an alumina, a zirconate, a titanate, an aluminate, a stannate, a niobate, a tantalate, a tungstate or a rare earth oxide.

15. The suspension plasma spray process of any preceding claim, where the metal oxide particle has an average particle size of 50 nanometers to 10 micrometers.

**FIG. 1**

**FIG. 2A**

**FIG. 2B**

EP 4 253 593 A1

PARTICLE SIZE 30 μM
GAS FLOW RATE 100 M/S

FIG. 3A

PARTICLE SIZE 30 μM
GAS FLOW RATE 50 M/S

FIG. 3B

PARTICLE SIZE 10 μM
GAS FLOW RATE 100 M/S

FIG. 3C

PARTICLE SIZE 10 μM
GAS FLOW RATE 50 M/S

FIG. 3D

Europäisches
Patentamt

European
Patent Office

Office européen
des brevets

**EUROPEAN SEARCH REPORT**

Application Number

EP 23 16 4842

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 431 631 A1 (UNITED TECHNOLOGIES CORP [US]) 23 January 2019 (2019-01-23) * paragraphs [0036], [0037], [0053], [0059]; claims 1-3, 7, 10 * | 1-15 | INV. C23C4/11 C23C4/134 |
| X | EP 3 421 636 A1 (ROLLS ROYCE CORP [US]; ROLLS ROYCE NAM TECH INC [US]) 2 January 2019 (2019-01-02) * paragraphs [0049] - [0057], [0078] - [0080]; claims 1-15 * | 1,12-15 | |
| X | US 2018/251881 A1 (HAZEL BRIAN T [US]) 6 September 2018 (2018-09-06) * paragraphs [0002], [0006], [0030] - [0033]; claims 1, 2, 15 * | 1,12-15 | |

TECHNICAL FIELDS
SEARCHED      (IPC)

C23C

The present search report has been drawn up for all claims

| Place of search | Date of completion of the search | Examiner |
|---|---|---|
| The Hague | 9 June 2023 | Chalaftris, Georgios |

EPO FORM 1503 03.82 (P04C01)

## ANNEX TO THE EUROPEAN SEARCH REPORT
## ON EUROPEAN PATENT APPLICATION NO.

EP 23 16 4842

This annex lists the patent family members relating to the patent documents cited in the above-mentioned European search report.
The members are as contained in the European Patent Office EDP file on
The European Patent Office is in no way liable for these particulars which are merely given for the purpose of information.

09-06-2023

| Patent document cited in search report | | Publication date | Patent family member(s) | | Publication date |
|---|---|---|---|---|---|
| EP 3431631 | A1 | 23-01-2019 | EP | 3431631 A1 | 23-01-2019 |
| | | | US | 2019024510 A1 | 24-01-2019 |
| | | | US | 2021040854 A1 | 11-02-2021 |
| EP 3421636 | A1 | 02-01-2019 | CA | 3002272 A1 | 26-12-2018 |
| | | | EP | 3421636 A1 | 02-01-2019 |
| | | | SG | 10201803000Q A | 30-01-2019 |
| | | | US | 2018371600 A1 | 27-12-2018 |
| US 2018251881 | A1 | 06-09-2018 | NONE | | |

EPO FORM P0459

For more details about this annex : see Official Journal of the European Patent Office, No. 12/82